# EUROPÄISCHE PATENTANMELDUNG

(11) **EP 1 628 343 A2**
(43) Veröffentlichungstag der Anmeldung: **22.02.2006**
(21) Anmeldenummer: 05013038.4
(22) Anmeldetag: 16.06.2005
(51) Int. Cl.: H01L 23/467

(54) **Kühlvorrichtung**

(30) Priorität: 12.08.2004 DE 102004039228
(71) Anmelder: Fujitsu Siemens Computers GmbH, 80807 München (DE)
(72) Erfinder: Riebel, Michael, 86438 Kissing (DE)
(74) Vertreter: Epping - Hermann - Fischer

(57) **Zusammenfassung**

Die Erfindung betrifft eine Kühlvorrichtung für ein elektronisches Bauelement, insbesondere im Computerbereich, mit einer Basisplatte (1) zum Aufsetzen auf das zu kühlende Bauelement, einem wärmeleitenden Kern (2), der mit der Basisplatte (1) verbunden ist, einem Lüfter (8) mit einer Rotationsachse (10) und einer Strömungsleitvorrichtung (3), die Strömungsleitbleche (4) aufweist, wobei die Strömungsleitbleche (3) mit dem Kern (2) verbunden sind und wobei der Kern (2) in Verlängerung der Rotationsachse (10) des Lüfters (8) in Richtung der Basisplatte (1) verläuft, gelöst. Die Kühlvorrichtung zeichnet sich dadurch aus, dass die Strömungsleitbleche (4) radial von dem Kern (2) wegführen und in Richtung der Rotationsachse (10) schraubenförmig um den Kern (2) gewunden sind, wodurch eine Verwirbelung des Luftstroms des Lüfters (8) durch die Strömungsleitbleche (4) verringert wird, was zu einem kleineren Strömungswiderstand für den Luftstrom und zu geringerer Geräuschentwicklung führt.

## Beschreibung

Die Erfindung betrifft eine Kühlvorrichtung für ein elektronisches Bauelement, insbesondere im Computerbereich, gemäß dem Oberbegriff des Anspruchs 1.

Zur Kühlung von elektronischen Bauelementen werden häufig Kühlkörper, die in einen möglichst guten thermischen Kontakt mit dem Bauelement gebracht werden, eingesetzt. Solche Kühlkörper zeichnen sich durch eine große Oberfläche aus und geben über Konvektion Wärme an die Umgebungsluft ab. Gerade im Computerbereich reicht bei steigender Integrationsdichte der eingesetzten Halbleiter-Bauelements eine passive Konvektionskühlung zur Wärmeabführung meist nicht aus. Es ist bekannt, dann Lüfter einzusetzen, deren Luftstrom direkt auf den Kühlkörper geleitet wird und die Konvektionsluftströmung unterstützt. Häufig wird der Lüfter dazu direkt auf den Kühlkörper aufgesetzt.

Um eine gute Kühlwirkung zu erzielen, ist es notwendig, dass der Luftstrom des Lüfters in leicht turbulenter Strömung an den Kühlrippen des Kühlkörpers vorbei strömt. Verglichen mit einer rein laminaren Strömung verbessert eine turbulente Strömung die Wärmeabfuhr, da sich kalte und warme Luft besser vermischen und so bereits aufgewärmte Luft leichter von den Kühlrippen abgeführt werden kann. Zu viel Verwirblung der Luftströmung erhöht allerdings den Strömungswiderstand nachteilig und verringert so den vom Lüfter an den Kühlrippen vorbeigeführten Luftstrom. Zudem führt ein Übermaß an Verwirblung durch turbulente Strömung zu störenden Nebengeräuschen, da entweder die Kühlrippen selber oder die zwischen ihnen stehende Luftsäule zu Schwingungen angeregt werden.

Neben diesen funktionellen Merkmalen sollte eine solche Kühlvorrichtung preisgünstig herstellbar sein, da sie anderenfalls in einem Massenmarkt wie dem der Computerkomponenten nicht positionierbar ist.

Aufgabe der vorliegenden Erfindung ist es daher, eine Kühlvorrichtung anzugeben, die bei guten Kühleigenschaften möglichst leise arbeitet und kostengünstig herstellbar ist.

Diese Aufgabe wird von einer Kühlvorrichtung mit einer Basisplatte zum Aufsetzen auf das zu kühlende Bauelement, einem wärmeleitenden Kern, der mit der Basisplatte verbunden ist, einem Lüfter mit einer Rotationsachse und einer Strömungsleitvorrichtung, die Strömungsleitbleche aufweist und die in Wärmekontakt mit der Basisplatte ist, wobei die Strömungsleitbleche mit dem Kern verbunden sind und wobei der Kern in Verlängerung der Rotationsachse des Lüfters in Richtung der Basisplatte verläuft, gelöst. Die Kühlvorrichtung zeichnet sich dadurch aus, dass die Strömungsleitbleche radial von dem Kern wegführen und in Richtung der Rotationsachse schraubenförmig um den Kern gewunden sind.

Bedingt durch meist schaufelförmige Lüfterblätter eines Lüfters und deren Drehung um die Rotationsachse des Lüfters produziert der Lüfter ein Strömungsfeld, dessen Hauptbewegungsrichtung in Richtung der Lüfterachse verläuft, das aber zusätzlich auch zur Rotationsachse tangentiale Bewegungskomponenten hat und bei dem die Luftströmung einen Drehimpuls in Richtung der Rotationsachse aufweist. Diese zusätzlichen Komponenten führen dazu, dass sich die Luftteilchen im Luftstrom entlang einer Schraubenlinie bewegen. Die Schraubenlinie ist konzentrisch zur Rotationsachse des Lüfters, wobei sich Ganghöhe und Radius der Schraubenlinie mit dem Abstand vom Lüfter ändern können.

Die erfindungsgemäßen Strömungsleitbleche, die gleichzeitig die Kühlrippen des Kühlkörpers bilden, sind ebenfalls schraubenförmig gewunden ausgeführt. Ihre Formgebung ist den Bewegungslinien des ungestörten Luftstroms nachempfunden, wodurch die erzwungene Bewegungsrichtung des Luftstroms in der Kühlvorrichtung im Wesentlichen der ungestörten Bewegungen des Luftstroms entspricht. Dadurch wird die Verwirbelung des Luftstroms durch die Strömungsleitbleche verringert, was zu einem kleineren Strömungswiderstand für den Luftstrom und zu geringerer Geräuschentwicklung führt. Dennoch ist natürlicherweise ein Mindestmaß an turbulenter Verwirbelung durch die Einschränkung des Gesamtradius des Luftstroms innerhalb der Kühlvorrichtung und auch durch die Kanten der Strömungsleitbleche gegeben. Darüber hinaus ermöglicht die Anordnung der Strömungsleitbleche, dass über den Kern eine gute Wärmeleitung zwischen Basisplatte und Strömungsleitblechen erzielt werden kann.

Weiterhin ist die erfindungsgemäße Kühlvorrichtung kostengünstig herstellbar, da die schraubenförmigen Strömungsleitbleche in einem Strangpressverfahren hergestellt werden können.

Weitere vorteilhafte Ausgestaltungen und Weiterbildungen der Erfindung sind in den Unteransprüchen angeführt.

Die Erfindung wird nachfolgend anhand eines in zwei Figuren dargestellten Ausführungsbeispiels näher erläutert. Die Figuren zeigen:
Figur 1 eine schematische Schnittansicht eines Ausführungsbeispiels der erfindungsgemäßen Kühlvorrichtung und
Figur 2 das Ausführungsbeispiel in einer Aufsicht ohne aufgesetzten Lüfter, entsprechend einer Schnittdarstellung entlang der Linie A in Figur 1.

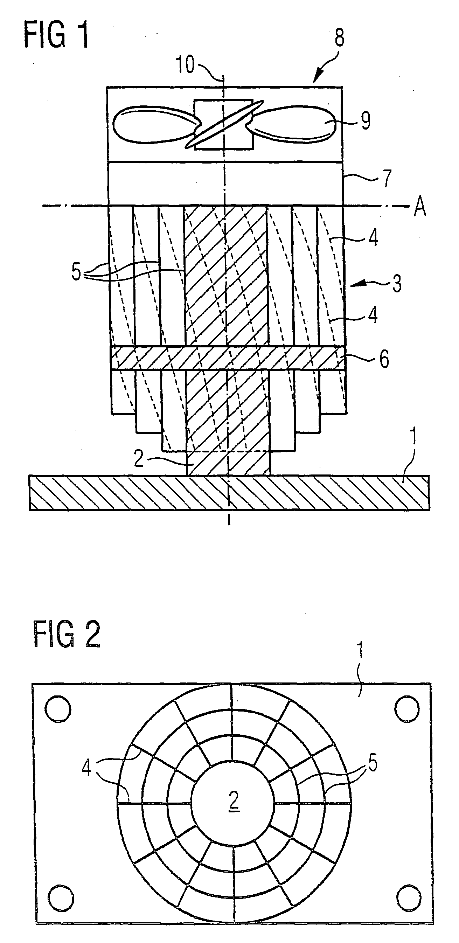

Figur 1 zeigt eine schematische Schnittdarstellung eines Ausführungsbeispiels der Kühlvorrichtung, wobei die Rotationsachse des eingesetzten Lüfters in der Schnittebene liegt. Auf einer Basisplatte 1, die auf ein hier nicht gezeigtes zu kühlendes Bauelement aufgesetzt wird, ist mittig und senkrecht zur Basisplatte 1 ein zylinderförmiger Kern 2 angebracht. Es ist auch ein anderer Winkel zwischen Basisplatte 1 und Kern 2 denkbar, beispielsweise aus Platzgründen. Der Kern ist mit einer Strömungsleitvorrichtung 3 verbunden, die aus Strömungsleitblechen 4 sowie weiteren Strömungsleitblechen 5 besteht. Senkrecht zum Kern 2 und mit diesem sowie mit der Strömungsleitvorrichtung 3 verbunden ist ein weiteres wärmeleitendes Element 6 vorgesehen. Oberhalb des Kerns 2 in der Strömungsleitvorrichtung 3 und von diesem durch einen Hohlraum 7 getrennt, ist ein Lüfter 8 angeordnet. Der Lüfter 8 weist Lüfterflügel 9 auf, die sich mit Hilfe eines nicht gezeigten Motors um eine Rotationsachse 10 des Lüfters 8 drehen.

Die Kühlvorrichtung wird mit der Basisplatte 1 auf das zu kühlende Bauelement aufgesetzt. Da die gesamte von der Kühlvorrichtung abtransportierte Wärme über die Basisplatte 1 geführt wird, ist diese aus einem gut wärmeleitenden Material wie Aluminium, Kupfer oder Legierungen, die diese Materialien enthalten, hergestellt. Um einen guten Wärmekontakt mit dem elektronischen Bauelement zu erzielen, ist die auf das Bauelement aufsetzende Fläche eben und glatt ausgeführt, gegebenenfalls geschliffen. Die Materialstärke der Basisplatte 1 ist so gewählt, dass die Basisplatte 1 sich auch bei dem zum Erreichen eines guten Wärmekontakts notwendigen Anpressdruck auf das zu kühlende Bauelement nicht verformt. Zur Befestigung sind im gezeigten Ausführungsbeispiel an den Ecken der Basisplatte 1 Löcher vorgesehen, wobei andere Befestigungsmethoden, wie z.B. Klammern, ebenfalls möglich sind. Auf der dem Bauelement abgewandten Seite der Basisplatte 1 ist mittig und senkrecht der Kern 2 angebracht. Dieser besteht günstigerweise aus dem gleichen gut wärmeleitenden Material wie die Basisplatte 1 und ist mit dieser wärmeleitend verbunden. Hierzu bieten sich eine stoffschlüssige Verbindung, eine Lötverbindung oder auch eine Schraubverbindung an. Um einen ausreichenden Wärmetransport zu gewährleisten, ist ein ausreichender Querschnitt des Kerns 2 vorzusehen. Der Kern 2 kann massiv ausgelegt sein. Falls das Kriterium der ausreichenden Wärmeleitfähigkeit gegeben ist, ist es zur Material- und Gewichtsersparnis allerdings auch möglich, den Kern 2 als ggf. dickwandiges Rohr auszuführen.

Vom Kern 2 radial nach außen weg verlaufen die schraubenförmig gewundenen Strömungsleitbleche 4. Die weiteren Strömungsleitbleche 5 sind zylinderförmig und konzentrisch zum Kern 2 um diesen angeordnet. Auch die Strömungsleitbleche 4 und die weiteren Strömungsleitbleche 5 sind aus gut wärmeleitenden Materialien, beispielsweise ebenfalls Aluminium oder Kupferwerkstoffen, gefertigt. Die Dicke dieser Strömungsleitbleche ist so gewählt, dass einerseits der für die Luftströmung zur Verfügung stehende Querschnitt nicht unnötig verkleinert wird und andererseits eine ausreichende Wärmeleitung gegeben ist. Da die radial verlaufenden Strömungsleitbleche 4 mehr Wärme transportieren als die konzentrischen weiteren Strömungsleitbleche 5, ist für sie ein größerer Materialquerschnitt geeignet. Idealerweise können die Strömungsleitbleche 4 so gefertigt sein, dass ihr Querschnitt zum Kern 2 hin zunimmt, da die von ihnen transportierte Wärmemenge ebenfalls zum Kern 2 hin steigt und nach außen hin abnimmt. Bei einer entsprechenden Auslegung der Strömungsleitbleche 4 mit sehr großem Querschnitt kann in einer alternativen Ausführungsform der Kern 2 gegebenenfalls entfallen. Die Strömungsleitbleche 4 verlaufen dann radial von einer Zentralachse nach außen weg, die die gedachte Verlängerung der Rotationsachse 10 des Lüfters 8 ist.

In radialer Richtung verlaufen die Strömungsleitbleche 4 senkrecht vom Kern 2 weg, in axialer Richtung laufen sie schraubenförmig gewunden am Kern 2 entlang. Die Ganghöhe dieser Schraubenlinie ist dabei dem Strömungsfeld der Luftströmung des Lüfters 8 angepasst. Sie kann durchaus größer sein als die Bauhöhe des Kerns 2.

In Figur 2 ist eine schematische Schnittzeichnung entlang der Linie A von Figur 1 senkrecht zum Kern 2 dargestellt. Sie verdeutlicht noch einmal die Anordnung der Strömungsleitbleche 4 sowie der weiteren Strömungsleitbleche 5 zueinander. Anzahl und damit auch Abstand der Strömungsleitbleche 4 und 5 sind lediglich beispielhaft anzusehen. Die Anzahl der Strömungsleitbleche 4 richtet sich vor allem nach thermischen und strömungstechnischen Gesichtspunkten. Von den Strömungsleitblechen 5 hat insbesondere das äußere als Begrenzung des Strömungsfeldes eine strömungstechnische Bedeutung. Die Anzahl der inneren weiteren Strömungsleitbleche 5 ist im Wesentlichen durch mechanische Gesichtspunkte gegeben, da sie der Struktur Stabilität verleihen.

Trotz ihrer komplexen Form kann die aus den Strömungsleitblechen 4 und den weiteren Strömungsleitblechen 5 gebildete Strömungsleitvorrichtung 3 in einfacher Weise einstückig in einem Strangpressverfahren hergestellt werden. Günstigerweise wird der Innendurchmesser der Strömungsleitvorrichtung 3 so gewählt, dass diese auf den Kern 2 aufschrumpfbar ist. Damit ist ein guter Wärmekontakt von dem Kern 2 zu den Strömungsleitblechen 4 gesichert. Vor dem Aufschrumpfen wird die Strömungsleitvorrichtung 3 auf der der Basisplatte 1 zugewandten Seite kegelförmig abgeschrägt, um so Luftaustrittsöffnungen zu bilden. Diese Luftaustrittsöffnungen leiten den Kühlluftstrom auf die Basisplatte 1, bevor er nach außen entweicht.

Zur Unterstützung der Wärmeleitung vom Kern 2 zu den äußeren Abschnitten der Strömungsleitvorrichtung 3 ist ein weiteres wärmeleitendes Element 6 vorgesehen. Dieses weitere wärmeleitende Element 6 kann in entsprechende Bohrungen der Wärmeleitvorrichtung 3 und des Kerns 2 eingesetzt werden. Das weitere wärmeleitende Element 6 kann ein massives, aus gute wärmeleitendem Material wie Kupfer oder Aluminium gefertigtes Element sein, es ist aber ebenfalls möglich, hier eine so genannte Heat Pipe einzusetzen, die sich durch große Wärmeleitfähigkeit bei kleinem Durchmesser auszeichnet.

Oberhalb von Kern 2 und Strömungsleitvorrichtung 3 ist der Lüfter 8 angeordnet. Es handelt sich dabei um einen so genannten Axiallüfter, bei dem sich die Lüfterflügel 9 um die Rotationsachse 10 drehen und ein Luftstrom in Richtung dieser Rotationsachse 10 erzeugt wird. Durch die Drehbewegung der Lüfterflügel 9 bedingt weisen die Luftteilchen im Luftstrom zusätzlich einen Drehimpuls in Richtung dieser Rotationsachse 10 auf. Dieser Drehimpuls führt zur Schraubenbewegung der Luftteilchen, an die die Strömungsleitbleche 4 in ihrer Formgebung angepasst sind. Insbesondere ist darauf zu achten, dass die Rotationsrichtung des Lüfters und der Drehsinn der schraubenförmigen Strömungsleitbleche 4 aufeinander abgestimmt sind. Zwischen dem Lüfter 8 und der Strömungsleitvorrichtung 3 ist im gezeigten Ausführungsbeispiel der Hohlraum 7 vorgesehen. Dieser Hohlraum 7 ist nach außen durch ein zylinderförmiges Element begrenzt, welches eine Fortsetzung des äußeren konzentrischen weiteren Strömungsleitbleches 5 darstellt. Dieser Hohlraum 7 ermöglicht einen gewissen Druckausgleich innerhalb des Strömungsfeldes des Lüfters 8 und ist dazu geeignet, eventuelle Anblasgeräusche an den oberen Kanten der Strömungsleitbleche 4 und 5 beim Eintritt des Luftstroms in die Strömungsleitvorrichtung 3 zu verringern. Diese Kammer ist optional und kann zugunsten einer kleineren Gesamtbauhöhe entfallen, ohne die Funktion der Kühlvorrichtung prinzipiell zu beeinträchtigen.

Lüfter, wie der hier gezeigte Lüfter 8, sind gängige Elemente von Kühlvorrichtungen nach dem Stand der Technik. Es ist daher bevorzugt, die erfindungsgemäße Kühlvorrichtung so auszugestalten, dass sie mit handelsüblichen Lüftern betrieben werden kann, was der Forderung nach preisgünstiger Herstellbarkeit entgegen kommt.

### Bezugszeichenliste

- 1: Basisplatte
- 2: Kern
- 3: Strömungsleitvorrichtung
- 4: Strömungsleitbleche
- 5: weitere Strömungsleitbleche
- 6: weiteres wärmeleitendes Element
- 7: Hohlraum
- 8: Lüfter
- 9: Lüfterflügel
- 10: Rotationsachse des Lüfters

## Patentansprüche

1. Kühlvorrichtung für ein elektronisches Bauelement mit
- einer Basisplatte (1) zum Aufsetzen auf das zu kühlende Bauelement,
- einem wärmeleitenden Kern (2), der mit der Basisplatte (1) verbunden ist,
- einem Lüfter (8) mit einer Rotationsachse (10),
- einer Strömungsleitvorrichtung (3), die Strömungsleitbleche (4) aufweist,
wobei die Strömungsleitbleche (4) mit dem Kern (2) verbunden sind und wobei der Kern (2) in Verlängerung der Rotationsachse (10) des Lüfters (8) in Richtung der Basisplatte (1) verläuft, **dadurch gekennzeichnet, dass**
die Strömungsleitbleche (4) radial von dem Kern (2) wegführen und in Richtung der Rotationsachse (10) schraubenförmig um den Kern (2) gewunden sind.

2. Kühlvorrichtung nach Anspruch 1, **dadurch gekennzeichnet, dass**
der wärmeleitende Kern (2) aus Kupfer oder Aluminium besteht.

3. Kühlvorrichtung nach einem der Ansprüche 1 oder 2, **dadurch gekennzeichnet, dass**
senkrecht zum Kern (2) mindestens ein weiteres wärmeleitendes Element (6) angeordnet ist, über das die Strömungsleitbleche (4) zusätzlich mit dem Kern (2) verbunden sind.

4. Kühlvorrichtung nach Anspruch 3, **dadurch gekennzeichnet, dass**
das weitere wärmeleitende Element (6) aus Kupfer oder Aluminium besteht.

5. Kühlvorrichtung nach Anspruch 3, **dadurch gekennzeichnet, dass**
das weitere wärmeleitende Element (6) eine Heat-Pipe ist.

6. Kühlvorrichtung nach einem der Ansprüche 1 bis 5, **dadurch gekennzeichnet, dass**
die Strömungsleitvorrichtung (3) konzentrisch um den Kern (2) angeordnete weitere Strömungsleitbleche (5) aufweist.

7. Kühlvorrichtung nach einem der Ansprüche 1 bis 6, **dadurch gekennzeichnet, dass**
die Strömungsleitbleche (4) und/oder die weiteren Strömungsleitbleche (5) aus Aluminium bestehen.

8. Kühlvorrichtung nach einem der Ansprüche 1 bis 7, **dadurch gekennzeichnet, dass**
die Strömungsleitbleche (4) und/oder die weiteren Strömungsleitbleche (5) an ihrer der Basisplatte (1) zugewandten Seite innen zum Kern (2) hin länger sind als außen, so dass radial umlaufend Luftein bzw. -austrittsöffnungen gebildet sind.

9. Kühlvorrichtung nach einem der Ansprüche 1 bis 8, **dadurch gekennzeichnet, dass**
die Strömungsleitvorrichtung (3) in einem Strangpressverfahren hergestellt ist.

10. Kühlvorrichtung nach einem der Ansprüche 1 bis 9, **dadurch gekennzeichnet, dass**
der Lüfter (8) bündig auf der Strömungsleitvorrichtung (3) angeordnet ist.

11. Kühlvorrichtung nach einem der Ansprüche 1 bis 10, **dadurch gekennzeichnet, dass**
der Lüfter (8) so angeordnet ist, dass zwischen Lüfter (8) und Strömungsleitvorrichtung (3) ein Hohlraum (7) geformt wird, und dass dieser Hohlraum 7 radial außen umlaufend durch einen Rohrabschnitt begrenzt ist.

12. Verwendung der Kühlvorrichtung nach einem der Ansprüche 1 bis 11 zur Kühlung von Bauelementen im Computerbereich, insbesondere von Prozessoren.
